# EUROPÄISCHE PATENTANMELDUNG

(11) **EP 1 077 111 A1**
(43) Veröffentlichungstag der Anmeldung: **21.02.2001**
(21) Anmeldenummer: 00115098.6
(22) Anmeldetag: 27.07.2000
(51) Int. Cl.: B24D 7/06, B24B 37/04, B24D 7/10, B24B 53/02

(54) **Werkzeug und Verfahren zum abrasiven Bearbeiten einer im wesentlichen ebenen Fläche**

(30) Priorität: 19.08.1999 DE 19939258
(71) Anmelder: Wacker Siltronic Gesellschaft für Halbleitermaterialien Aktiengesellschaft, 84489 Burghausen (DE)
(72) Erfinder: Ripper, Bert, 02353 Postbauer-Heng (DE); Grubmüller, Hubert, 5222 Munderfing (AT)
(74) Vertreter: Rimböck, Karl-Heinz, Dr.

(57) **Zusammenfassung**

Die Erfindung betrifft Werkzeug und Verfahren zum abrasiven Bearbeiten einer im wesentlichen ebenen Fläche. Das Werkzeug umfaßt einen Grundkörper (1) und mehrere Elemente (2), die auf dem Grundkörper (1) montiert sind und einen ebenen Belag bilden, der als Arbeitsbelag beim Bearbeiten der Fläche eingesetzt wird.

## Beschreibung

Die Erfindung betrifft ein Werkzeug und ein Verfahren zum abrasiven Bearbeiten einer im wesentlichen ebenen Fläche. Gattungsgemäße Werkzeuge sind insbesondere Läppscheiben und Schleifscheiben, die zur Bearbeitung von scheibenförmigen Werkstücken, insbesondere von Halbleiterscheiben benötigt werden, und Abrichtringe, die eingesetzt werden, um die Arbeitsflächen von Läppscheiben und Schleifscheiben einzuebnen.

Es ist üblich, ein solches Werkzeug aus einem Gußteil zu fertigen und dieses durch mechanisches Bearbeiten und gegebenenfalls lokales Nachhärten auf seinen Einsatz vorzubereiten. Insbesondere, wenn das Werkzeug in Verbindung mit der Herstellung von Halbleiterscheiben benötigt wird, muß es strengen Qualitätsanforderungen genügen. So sind Schwankungen in Bezug auf die Härte und die Struktur des Kristallgefüges (Gefügestruktur) des Werkzeugs in möglichst engen Toleranzbereichen zu halten. Insbesondere wenn es sich um ein Werkzeug mit einer großflächigen Arbeitsfläche handelt, ist dieses Erfordernis nur mit erheblichem maschinentechnischen Aufwand zu erfüllen. Die Verwendung eines Werkzeugs mit unterschiedlichen lokalen Härten und nicht-homogener Gefügestruktur ist jedenfalls nicht akzeptabel, da Werkstücke damit nicht gleichmäßig bearbeitet werden können.

Die Erfindung zeigt einen Weg auf, wie das Erfordernis auf eine einfachere und vorteilhaftere Weise zu erfüllen ist.

Gegenstand der Erfindung ist ein Werkzeug zum abrasiven Bearbeiten einer im wesentlichen ebenen Fläche, das gekennzeichnet ist durch einen Grundkörper und mehrere Elemente, die auf dem Grundkörper montiert sind und einen ebenen Belag bilden, der als Arbeitsbelag beim Bearbeiten der Fläche eingesetzt wird.

Gegenstand der Erfindung ist auch ein Verfahren zum abrasiven Bearbeiten einer im wesentlichen ebenen Fläche mit einem Werkzeug, das dadurch gekennzeichnet ist, daß mehrere Elemente auf einen Grundkörper montiert werden, wobei die Elemente einen ebenen Belag bilden, der als Arbeitsbelag beim Bearbeiten der Fläche eingesetzt wird.

Die Erfindung hat mehrere besondere Vorteile: Die geringere zum Gießen eines Elements benötigte Gußmasse läßt sich leichter kontrollieren, so daß bereits beim Gießen der Elemente Körper mit einer homogeneren Gefügestruktur und Härte erhalten werden, als dies bei einem einteiligen Gußkörper mit der Masse mehrerer Elemente der Fall wäre. Des weiteren lassen sich mehrere einzelne Elemente einfacher nachbearbeiten als ein Gußkörper mit gleicher Masse. Von besonderem Vorteil ist auch, daß die einzelnen Elemente auf ihre Eigenschaften wie Gefügestruktur und Härte untersucht und zur Verwendung im Werkzeug ausgewählt werden können. Auf diese Weise ist ein Werkzeug erhältlich, dessen Eigenschaften wie beispielsweise dessen Härte und Gefügestruktur in einem besonders engen Toleranzbereich liegen und die auf die mit dem Werkzeug zu lösende Aufgabe genau abgestimmt sind. Ein Element, das nicht ausgewählt wurde, beispielsweise weil dessen Härte nicht im geforderten Toleranzbereich lag, wird aufbewahrt, bis ein Werkzeug für eine Aufgabe bereitgestellt werden muß, zu deren Lösung ein Arbeitsbelag benötigt wird, dessen Eigenschaften denen dieses Elements entsprechen.

Der Grundkörper unterliegt im Gegensatz zu den Elementen kaum einem Verschleiß und kann deshalb wesentlich häufiger als die Elemente wiederverwendet werden. Es ist bevorzugt, daß ein Grundkörper nur auf einer einzigen Maschine eingesetzt wird. Dadurch werden längere Einfahrzeiten vermieden, die bei einem Werkzeugwechsel notwendig sind. Besonders bevorzugt ist es daher, für eine Maschine zwei Grundkörper bereitzustellen, die im Wechsel auf dieser Maschine eingesetzt werden.

Die Elemente werden nach Erreichen eines vorgesehenen Verschleißgrades ausgewechselt. Der von den Elementen gebildete Belag kann 2 bis 4000, vorzugsweise 3 bis 2500 Elemente umfassen. Die Elemente sind als Formkörper ausgebildet, die vorzugsweise die Kontur von Kreisringsegmenten, Kreisringen oder regelmäßigen Vielecken mit 3 bis 400 Ecken, besonders bevorzugt 4 bis 6 Ecken, besitzen.

Das erfindungsgemäße Werkzeug ist vorzugsweise als Läppscheibe zum Läppen oder als Schleifscheibe zum Schleifen von scheibenförmigen Werkstücken wie Halbleiterscheiben oder als Abrichtwerkzeug zum abrasiven Bearbeiten solcher Läpp- und Schleifscheiben ausgebildet. In den nachfolgend beschriebenen Figuren sind bevorzugte Ausführungsformen erfindungsgemäßer Werkzeuge schematisch dargestellt.
Fig.1 zeigt den Querschnitt durch ein Abrichtwerkzeug zum abrasiven Bearbeiten zweier sich gegenüberliegender Läpp- oder Schleifscheiben;
Fig.2 zeigt den Querschnitt durch ein als Läpp- oder Schleifscheibe ausgebildetes Werkzeug;
In den Fig. 3 bis 5 sind bevorzugt verwendete Elemente in Draufsicht dargestellt.

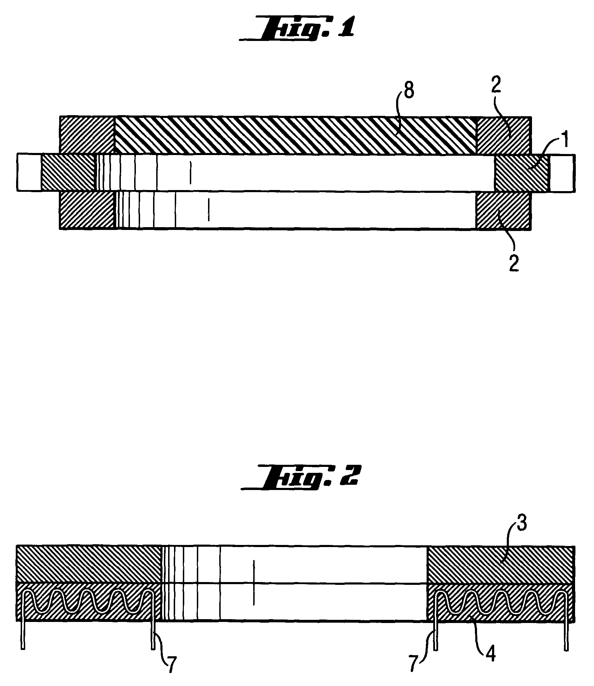

Das Abrichtwerkzeug in Fig.1 besteht aus einem ringförmigen Grundkörper 1, auf dem beidseitig Elemente 2 montiert sind. Der Grundkörper 1 besitzt an seinem äußeren Umfang eine Verzahnung, wie sie auch bei Trägerscheiben (carrier) zur Aufnahme scheibenförmiger Werkstücke von Läpp- oder Schleifmaschinen üblich ist. Zum Abrichten der Läpp- oder Schleifscheiben solcher Maschinen wird der Grundkörper 1 mit Elementen 2 bestückt und an Stelle einer Trägerscheibe zwischen die untere und obere Läpp- oder Schleifscheibe der Läpp- oder Schleifmaschine gesetzt und gegebenenfalls unter Zuführung eines abrasiv wirkenden Läppmittels in Drehung versetzt. Bei Zuführung eines Läppmittels ist es von Vorteil einen Grundkörper mit einer größeren Ringbreite oder einen Grundkörper, der als Kreisscheibe ausgebildet ist, zu verwenden, um zu verhindern, daß das Läppmittel unkontrolliert nach unten abläuft. Gemäß einer bevorzugten Ausführungsform der Erfindung wird die Kreisringbohrung des Grundkörpers mit einer Kunststoffscheibe 8 verschlossen. Der Grundkörper wird durch den Abrichtvorgang wesentlich weniger beansprucht, so daß dessen Gebrauchsdauer die der Elemente deutlich übersteigt. Die Elemente werden in Abständen auf ihren Verschleiß hin überprüft und nach Erreichen eines vorgegebenen Verschleißgrades ausgewechselt.

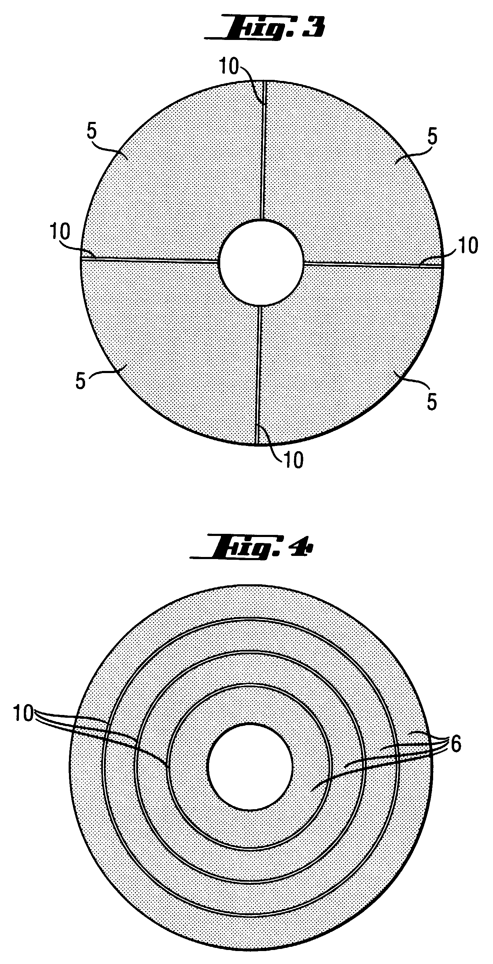

Das in Fig.2 dargestellte, als Läpp- oder Schleifwerkzeug ausgebildete Werkzeug umfaßt einen Grundkörper 4, der als Kreisscheibe ausgebildet ist und mehrere Elemente 3, die einseitig auf den Grundkörper montiert sind. Der Grundkörper verfügt über eine aktive Kühlung 7, die eine effektive Wärmeabfuhr beim Einsatz des Werkzeugs gewährleistet. Bei Verwendung einer Vielzahl von Elementen kann das bei Läppscheiben übliche Schlitzen des - Belags weggelassen und damit ein den Einsatz des Werkzeugs vorbereitender Arbeitsgang eingespart werden. Mit dem Schlitzen von Läppscheiben ist das Anbringen von langgezogenen, sich kreuzenden Grabenstrukturen im Arbeitsbelag der Läppscheibe gemeint. Damit werden Kanäle ausgebildet, die Flüssigkeit vom Läppmittel aufnehmen können. Die Funktion solcher Kanäle bilden gemäß einer bevorzugten Ausführungsform der Erfindung Fugen zwischen den Elementen. Bei der Montage der Elemente auf den Grundkörper werden die Elemente so gesetzt, daß entsprechende Fugen zwischen den Elementen entstehen. Besonders bevorzugt ist es, die Form der Elemente und die Fugenbreite so zu wählen, daß die Struktur der Oberfläche des Belags der geschlitzter Läppscheiben ähnlich ist.

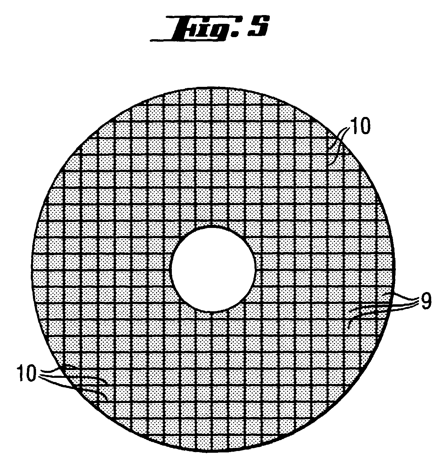

Bevorzugte Formen und Anordnungen der Elemente auf dem Grundkörper sind in den Figuren 3-5 dargestellt. In Figur 3 sind Elemente 5 gezeigt, die die Kontur von Kreisringsegmenten aufweisen und derart nebeneinander angeordnet sind, daß sie den kreisringförmigen Grundkörper abdecken. In Figur 4 sind kreisringförmige Elemente 6 dargestellt, die als konzentrisch liegende Ringe den Grundkörper abdecken. Figur 5 zeigt überwiegend viereckige Elemente 9, die die Oberfläche des Grundkörpers weitgehend abdecken. Die Elemente 5, 6 und 9 sind voneinander beabstandet angeordnet, so daß sich Fugen 10 ausbilden. In Bereichen, in denen die Elemente den Rand des Grundkörpers abdecken, sind ihre Ecken entsprechend verrundet. Sind auf dem Grundkörper eine Vielzahl von Elementen mit entsprechend geringer Grundfläche montiert, kann in den Randbereichen auf eine Belegung des Grundkörpers mit Elementen verzichtet werden.

## Patentansprüche

1. Werkzeug zum abrasiven Bearbeiten einer im wesentlichen ebenen Fläche, gekennzeichnet durch einen Grundkörper und mehrere Elemente, die auf dem Grundkörper montiert sind und einen ebenen Belag bilden, der als Arbeitsbelag beim Bearbeiten der Fläche eingesetzt wird.

2. Werkzeug nach Anspruch 1, dadurch gekennzeichnet, daß der Grundkörper mit einer aktiven Kühlung versehen ist.

3. Werkzeug nach Anspruch 1 oder Anspruch 2, dadurch gekennzeichnet, daß die Elemente als Formkörper mit einer Kontur ausgebildet sind, die der Kontur von Kreisringen, Kreisringsegmenten und regelmäßigen Vielecken entspricht.

4. Werkzeug nach einem der Ansprüche 1 bis 3, dadurch gekennzeichnet, daß die Elemente aus Metallguß sind und eine im wesentlichen gleichartige Gefügestruktur und Härte besitzen.

5. Werkzeug nach einem der Ansprüche 1 bis 4, dadurch gekennzeichnet, daß das Werkzeug als Läppscheibe zum Lappen von scheibenförmigen Werkstücken ausgebildet ist.

6. Werkzeug nach einem der Ansprüche 1 bis 4, dadurch gekennzeichnet, daß das Werkzeug als Schleifscheibe zum Schleifen von scheibenförmigen Werkstücken ausgebildet ist.

7. Werkzeug nach einem der Ansprüche 1 bis 4, dadurch gekennzeichnet, daß das Werkzeug als Abrichtwerkzeug zum abrasiven Bearbeiten von Läppscheiben oder Schleifscheiben ausgebildet ist.

8. Werkzeug nach einem der Ansprüche 1 bis 7, gekennzeichnet durch einen Grundkörper, der als Kreisring ausgebildet ist und eine Kreisringbohrung aufweist, die mit einer Kunststoffscheibe verschlossen ist.

9. Verfahren zum abrasiven Bearbeiten einer im wesentlichen ebenen Fläche mit einem Werkzeug, dadurch gekennzeichnet, daß mehrere Elemente auf einen Grundkörper montiert werden, wobei die Elemente einen ebenen Belag bilden, der als Arbeitsbelag beim Bearbeiten der Fläche eingesetzt wird.

10. Verfahren nach Anspruch 9, dadurch gekennzeichnet, daß die Elemente durch Gießen von Metall hergestellt werden und nur solche Elemente auf den Grundkörper montiert werden, die eine im wesentlichen gleichartige Gefügestruktur und Härte aufweisen.

11. Verfahren nach Anspruch 9 oder Anspruch 10, dadurch gekennzeichnet, daß die Elemente nach Erreichen eines bestimmten Verschleißgrades ausgewechselt werden.

12. Verfahren nach einem der Ansprüche 9 bis 11, dadurch gekennzeichnet, daß der Grundkörper aktiv gekühlt wird.

13. Verfahren nach einem der Ansprüche 9 bis 12, dadurch gekennzeichnet, daß der Grundkörper ausschließlich in Verbindung mit einer bestimmten Maschine eingesetzt wird.
